# EUROPEAN PATENT APPLICATION

(11) **EP 4 787 831 A1**
(43) Date of publication of application: **05.08.2026**
(21) Application number: 24871896.7
(22) Date of filing: 12.09.2024
(51) Int. Cl.: H04N 5/74

(54) **INFORMATION PROCESSING METHOD AND INFORMATION PROCESSING SYSTEM**

(30) Priority: 29.09.2023 JP 2023169572
(71) Applicant: Panasonic Projector & Display Corporation, Kadoma-shi, Osaka 571-8503 (JP)
(72) Inventor: TERAOKA, Yasuko, Osaka 571-0057 (JP); ISHIZUKA, Mitsuhiro, Osaka 571-0057 (JP)
(74) Representative: Eisenführ Speiser
(86) International application number: PCT/JP2024/032748
(87) International publication number: WO 2025/070101

(57) **Abstract**

An information processing method includes the first display processing and the second display processing. The first display processing is processing of causing the display unit (52) to display one or more pieces of group information each including information regarding the output device (2) that outputs predetermined information and information regarding the acquisition device (3) that acquires the predetermined information output by the output device 2. The second display processing is processing of causing the display unit (52) to display, in a case where any group information among the one or more pieces of group information is selected: an overhead view illustrating installation locations of the output device (2) and the acquisition device (3) included in the selected group information; and objects indicating the output device (2) and the acquisition device (3).

## Description

### TECHNICAL FIELD

The present disclosure relates to an information processing method and an information processing system.

### BACKGROUND ART

Patent Document 1 discloses a monitoring system. The monitoring system includes a monitoring device and a plurality of monitoring cameras communicably connected to the monitoring device via a network. The monitoring device is connected to two monitors and displays videos transmitted from the monitoring cameras.

### PRIOR ART DOCUMENT

### PATENT DOCUMENT

Patent Document 1: JP 2014-171054 A

### SUMMARY OF INVENTION

### PROBLEMS TO BE SOLVED BY INVENTION

The present disclosure provides an information processing method and the like that make it easy to grasp not only information regarding an output device that outputs predetermined information but also information regarding an acquisition device that acquires the predetermined information output by the output device.

### SOLUTIONS TO THE PROBLEMS

An information processing method according to one aspect of the present disclosure includes first display processing and second display processing. The first display processing is processing of causing a display unit to display one or more pieces of group information each including information regarding an output device that outputs predetermined information and information regarding an acquisition device that acquires the predetermined information output by the output device. The second display processing is processing of causing the display unit to, in a case where any group information among the one or more pieces of group information is selected: an overhead view illustrating installation locations of the output device and the acquisition device included in the selected group information; and objects indicating the output device and the acquisition device.

### EFFECTS OF INVENTION

The present disclosure has an advantage that not only information regarding an output device that outputs predetermined information but also information regarding an acquisition device that acquires the predetermined information output by the output device can be easily grasped.

### BRIEF DESCRIPTION OF THE DRAWINGS

Fig. 1 is a block diagram illustrating an overall configuration including an information processing system according to an embodiment.
Fig. 2 is a diagram illustrating an example of information stored in a group management database.
Fig. 3 is a diagram illustrating an example of information stored in an adjustment log database.
Fig. 4 is a flowchart illustrating an example of registering information in the group management database by execution of simulation.
FIG. 5 is a flowchart illustrating an example of registering information in the group management database by execution of initial adjustment processing.
Fig. 6 is a flowchart illustrating an operation example of the information processing system according to the embodiment.
Fig. 7 is a diagram illustrating a basic display example on a display unit of an information processing terminal according to the embodiment.
Fig. 8 is a diagram illustrating a first display example on the display unit of the information processing terminal according to the embodiment.
Fig. 9 is a diagram illustrating a second display example on the display unit of the information processing terminal according to the embodiment.
Fig. 10 is a flowchart illustrating an example of third display processing of the information processing system according to the embodiment.
Fig. 11 is a flowchart illustrating a specific example of the third display processing by the information processing system according to the embodiment.
Fig. 12 is a diagram illustrating a third display example on the display unit of the information processing terminal according to the embodiment.
Fig. 13 is a diagram illustrating a fourth display example on the display unit of the information processing terminal according to the embodiment.
Fig. 14 is a diagram illustrating a fifth display example on the display unit of the information processing terminal according to the embodiment.
Fig. 15 is a diagram illustrating a sixth display example on the display unit of the information processing terminal according to the embodiment.
Fig. 16 is a diagram illustrating a seventh display example on the display unit of the information processing terminal according to the embodiment.
Fig. 17 is a diagram illustrating an eighth display example on the display unit of the information processing terminal according to the embodiment.

### DETAILED DESCRIPTION

### [1. Knowledge underlying the present disclosure]

First, the inventor's insight will be described below.

Conventionally, there has been known a system that monitors whether or not an error such as deviation of an image projected by a projector occurs by capturing a video projected by the projector with a camera. However, in the system, there is a problem that while the user can grasp a state of the projector as a monitoring target, the user cannot intuitively grasp which camera is monitoring the projector as a monitoring target. Therefore, there is a problem that the user who uses the system needs to perform work of associating, with a projector as a monitoring target, a camera that captures a video projected by the projector, and work required for constructing the system tends to be complicated. Further, in the system, there is also a problem that the user may associate an incorrect camera with a projector.

In view of the above, the inventor has created the present disclosure.

Hereinafter, an embodiment will be described with reference to the drawings. Note that all the embodiments described below illustrate a comprehensive or specific example. Numerical values, shapes, materials, components, arrangement positions and connection modes of components, steps, order of steps, and the like shown in the following embodiments are merely examples, and are not intended to limit the present disclosure. Among components in the embodiment below, a component not described in an independent claim is described as an optional component.

Note that each drawing is a schematic diagram, and is not necessarily strictly illustrated. Further, in the drawings, substantially the same components are denoted by the same reference numerals, and redundant description may be omitted or simplified.

### (Embodiment)

### [2. Configuration]

### [2-1. Overall configuration]

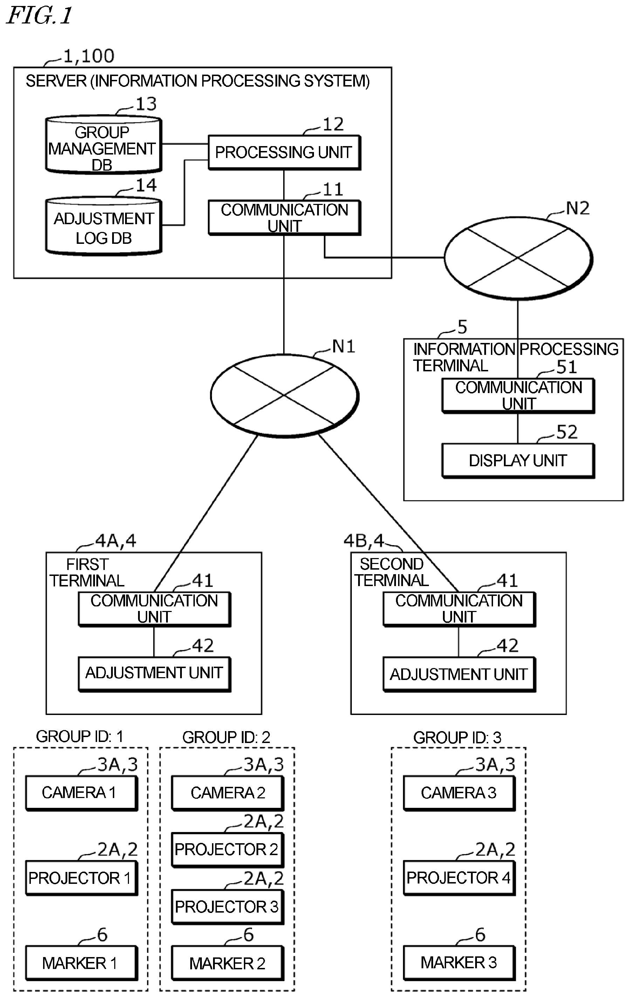

First, an overall configuration including an information processing system 100 according to an embodiment will be described. Fig. 1 is a block diagram illustrating an overall configuration including the information processing system 100 according to an embodiment. The information processing system 100 is a system for managing a projector 2A which is an output device 2 and a camera 3A which is an acquisition device 3. In the embodiment, the information processing system 100 manages one or more groups with the output device 2 and the acquisition device 3 as one group. In the embodiment, the information processing system 100 is realized by the server 1.

Here, the output device 2 is a device that outputs predetermined information. For example, the projector 2A is a device that projects a video onto a display surface such as a screen or a wall surface, and is a display device that outputs predetermined information (video). In the embodiment, a video may be projected on a display surface by the projector 2A, one in number, or a video may be projected on a display surface by a plurality of the projectors 2A. In the latter case, a video is projected on a display surface by multi-projection in which one video is constructed by a video projected by each of the plurality of projectors 2A.

Further, the acquisition device 3 is a device that acquires predetermined information output from the output device 2. For example, the camera 3A is a device that captures a video projected by the projector 2A, and is a device that acquires predetermined information (video) output by the output device 2 (projector 2A). In the embodiment, the camera 3A is used to monitor a video projected onto a display surface by the corresponding one or more projectors 2A. Further, the camera 3A is used to execute adjustment processing of adjusting a position or the like of a video projected on a display surface by the corresponding one or more projectors 2A.

Note that, when adjustment processing using the camera 3A is executed, for example, one or more markers 6 such as a light-emitting marker like a Light Emitting Diode (LED) marker are used. The marker 6 is installed at one or more positions (for example, four corners of a projection area, and the like) serving as a reference of a projection area of a video in an imaging area of the camera 3A.

In the embodiment, the server 1 (the information processing system 100) is used together with the one or more projectors 2A, the one or more cameras 3A, one or more terminals 4 (here, a first terminal 4A and a second terminal 4B), and an information processing terminal 5. The server 1, the one or more projectors 2A, the one or more cameras 3A, and the one or more terminals 4 can communicate with each other via a network N1 such as the Internet or a Local Area Network (LAN). Further, the server 1 and the information processing terminal 5 can communicate with each other via a network N2 different from the network N1 such as the Internet or a LAN.

The terminal 4 is a terminal used at an installation location where the one or more projectors 2A and the one or more cameras 3A are installed, and is, for example, a desktop or laptop personal computer, a tablet terminal, or the like. Here, as illustrated in Fig. 1, the terminal 4 used at an installation location (hereinafter, also referred to as "first installation location") where "Projector 1", "Projector 2", and "Projector 3" which are the projectors 2A, "Camera 1" and "Camera 2" which are the cameras 3A, and "Marker 1" and "Marker 2" which are the markers 6 are installed is referred to as "first terminal 4A". Furthermore, here, as illustrated in Fig. 1, the terminal 4 used at an installation location (hereinafter, also referred to as "second installation location") where "Projector 4" which is the projector 2A, "Camera 3" which is the camera 3A, and "Marker 3" which is the marker 6 are installed is referred to as "second terminal 4B".

The terminal 4 includes a communication unit 41 and an adjustment unit 42. The adjustment unit 42 is implemented by a processor of the terminal 4 through execution of a computer program stored in a memory.

The communication unit 41 is a communication interface for communicating with the server 1 (information processing system 100). The communication unit 41 transmits an adjustment log, which is an execution result of adjustment processing by the adjustment unit 42, to the server 1 via the network N1. Note that communication between the communication unit 41 and the server 1 may be wired communication or wireless communication.

The adjustment unit 42 executes adjustment processing. The adjustment unit 42 first causes the one or more corresponding cameras 3A to capture a video projected on a display surface by the one or more projectors 2A. Then, the adjustment unit 42 executes adjustment processing of adjusting a position and the like of a video by using an image captured by the one or more cameras 3A. The adjustment processing includes, for example, processing such as geometric correction, black level adjustment, white balance adjustment, luminance adjustment, focus adjustment, hue adjustment, or uniformity adjustment. The adjustment processing may be processing of automatically adjusting a corresponding parameter such that each of one or more parameters to be adjusted (for example, a geometric correction parameter or the like) are within a preset range. Further, the adjustment processing may be processing in which the user manually adjusts each of one or more parameters to be adjusted as appropriate by using a Graphical User Interface (GUI) dedicated to the adjustment processing.

The information processing terminal 5 is, for example, a terminal used by the user who utilizes the information processing system 100, and is, for example, a smartphone, a desktop or laptop personal computer, a tablet terminal, or the like. The information processing terminal 5 includes a communication unit 51 and a display unit 52.

The communication unit 51 is a communication interface for communicating with the server 1 (information processing system 100). The communication unit 51 receives various types of information transmitted from the server 1 via the network N2. Further, the communication unit 51 transmits information input by the user thorough operation of the information processing terminal 5 to the server 1 via the network N2. Note that communication between the communication unit 51 and the server 1 may be wired communication or wireless communication.

The display unit 52 is, for example, a liquid crystal display, an organic Electroluminescence (EL) display, or the like, and displays various types of information transmitted from the server 1 (information processing system 100). Various types of information displayed on the display unit 52 will be described in detail in [3. Operation] described later.

### [2-2. Information processing system]

Next, a configuration of the information processing system 100 will be described in detail. As described above, in the embodiment, the information processing system 100 is implemented by the server 1. The information processing system 100 includes a communication unit 11, a processing unit 12, a storage device in which a group management database (hereinafter, referred to as "DB") 13 is stored, and a storage device in which an adjustment log DB 14 is stored. The processing unit 12 may be implemented by a dedicated circuit, or may be implemented by a processor thorough execution of a computer program stored in a memory. Note that the storage device in which the group management DB 13 is stored and the storage device in which the adjustment log DB 14 is stored do not need to be included in the server 1, and may be an external storage device different from the server 1.

The communication unit 11 is a communication interface for communicating with each of the one or more terminals 4 and the information processing terminal 5. The communication unit 11 receives various types of information transmitted from each of the terminals 4 via the network N1. Further, the communication unit 11 transmits various types of information to the information processing terminal 5 via the network N2. Note that the communication interface for communicating with each of the terminals 4 and the communication interface for communicating with the information processing terminal 5 may be different from each other or the same.

The processing unit 12 executes processing of causing the display unit 52 of the information processing terminal 5 to display various types of information. Specifically, the processing unit 12 executes first display processing, second display processing, and third display processing. Note that in the embodiment, the processing unit 12 executes the second display processing, but does not need to have a function of executing the third display processing.

The first display processing is processing of causing the display unit 52 to display one or more pieces of group information. The one or more pieces of group information include information regarding the projector 2A (output device 2) and information regarding the camera 3A (acquisition device 3). In the example illustrated in Fig. 1, group information about the group with "Group identifier (ID): 1" includes at least information regarding the "Projector 1" which is the output device 2 and information regarding "Camera 1" which is the acquisition device 3, and further includes information regarding "Marker 1" which is the marker 6. The one or more pieces of group information displayed on the display unit 52 by the first display processing will be described in detail in [3. Operation] described later.

Here, the information regarding the output device 2 may include at least information that can distinguish the output device 2 from other devices, and may include, for example, an identifier, a name, or the like of the output device 2. Further, the information regarding the acquisition device 3 may include at least information that can distinguish the acquisition device 3 from other devices, and may include, for example, an identifier, a name, or the like of the acquisition device 3.

The second display processing is processing executed in a case where any group information of one or more pieces of group information is selected. Selection of group information is performed, for example, by the user who views one or more pieces of group information displayed on the display unit 52 through operation of the information processing terminal 5. The second display processing is processing of causing the display unit 52 to display an overhead view illustrating installation locations of the projector 2A (output device 2) and the camera 3A (acquisition device 3) included in the selected group information, and objects indicating the projector 2A and the camera 3A. The overhead view and the objects displayed on the display unit 52 by the second display processing will be described in detail in [3. Operation] described later.

Further, in the embodiment, the second display processing includes processing of further causing the display unit 52 to display state information indicating a state of each of the projector 2A (output device 2) and the camera 3A (acquisition device 3). The state information may include, for example, information indicating whether or not each of the projector 2A and the camera 3A is turned on, information indicating whether or not each of the projector 2A and the camera 3A is normally operating, or the like. Further, the state information may include, for example, information indicating a projection area of the projector 2A, information indicating an imaging area of the camera 3A, or the like.

The third display processing is processing of causing the display unit 52 to display notification information indicating a change in the state information in a case where a state of at least one of the projector 2A (output device 2) and the camera 3A (acquisition device 3) changes from a reference state. For example, it is assumed that a state in which the projector 2A is normally operating is the reference state. In this case, in the third display processing, in a case where any abnormality occurs in the projector 2A, notification information indicating that the abnormality occurs in the projector 2A is displayed on the display unit 52. The notification information displayed on the display unit 52 will be described in detail in [3. Operation] described later.

Further, the processing unit 12 processes various types of information acquired from each of the one or more terminals 4, and executes processing of causing the group management DB 13 and the adjustment log DB 14 to store the processed various types of information. The processing will be described in detail in [3. Operation] described later.

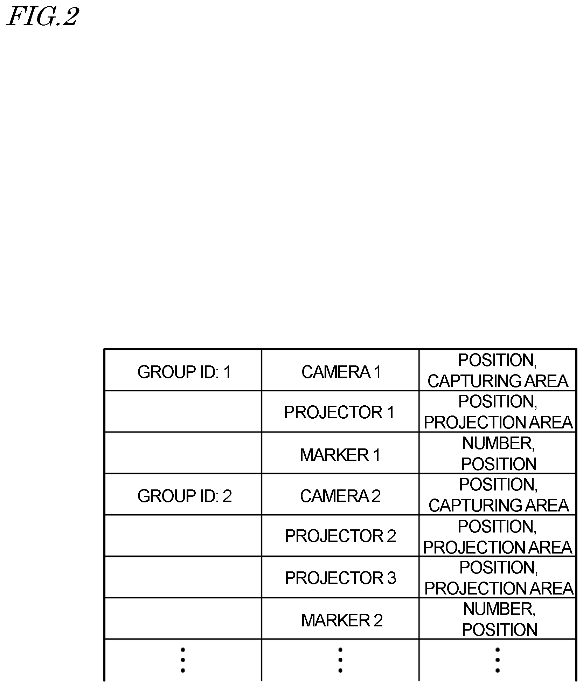

The group management DB 13 is a data set related to one or more pieces of group information. Fig. 2 is a diagram illustrating an example of information stored in the group management DB 13. As illustrated in Fig. 2, for each group, the group management DB 13 stores a group ID which is an identifier of the group, information indicating one or more devices included in the group, and an initial value of an adjustment parameter of each of the one or more devices in association with each other. Note that, in the group management DB 13, for example, one or more identifiers assigned to one or more devices are stored as information indicating one or more devices. Here, for example, in a case where the device is the projector 2A, the adjustment parameters are a position and a projection area of the projector 2A, in a case where the device is the camera 3A, the adjustment parameters are a position and an imaging area of the camera 3A, and in a case where the device is the marker 6, the adjustment parameters are the number and positions of the markers 6.

For example, a group indicated by "Group ID: 1" is associated with each identifier of "Camera 1", "Projector 1", and "Marker 1", an initial value of a position and an imaging area of "Camera 1", an initial value of a position and a projection area of "Projector 1", and an initial value of a position and the number of "Marker 1".

Further, in a case where simulation described later is executed, 3D data generated by the simulation is also stored in association with a group ID in the group management DB 13.

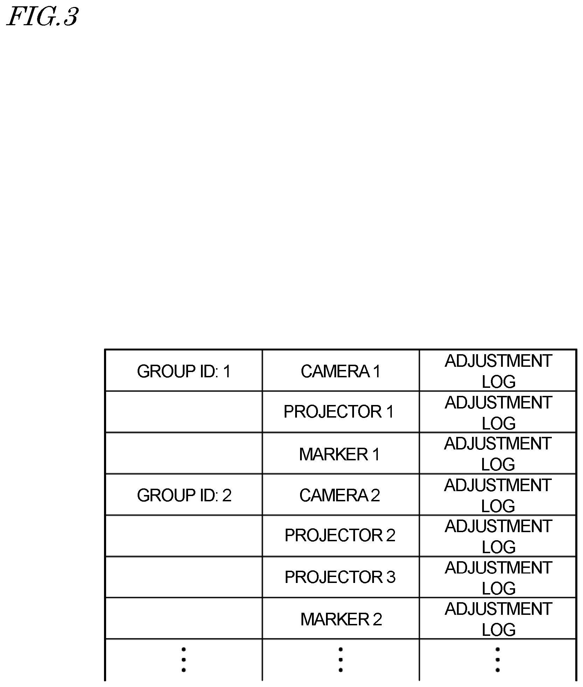

The adjustment log DB 14 is a data set related to an adjustment log. Fig. 3 is a diagram illustrating an example of information stored in the adjustment log DB 14. As illustrated in Fig. 3, the adjustment log DB 14 stores, for each group, a group ID which is an identifier of the group, information indicating one or more devices included in the group, and an adjustment log indicating an adjustment parameter of each of the one or more devices in association with each other. Note that, in the adjustment log DB 14, for example, one or more identifiers assigned to one or more devices are stored as information indicating one or more devices.

For example, a group indicated by "Group ID: 2" is associated with each identifier of "Camera 2", "Projector 2", "Projector 3", and "Marker 2", an adjustment log (position and imaging area) of "Camera 2", an adjustment log (position and projection area) of "Projector 2", an adjustment log (position and projection area) of "Projector 3", and an adjustment log (the number and position) of "Marker 2".

### [3. Operation]

Hereinafter, an operation of the information processing system 100 according to the embodiment will be described.

### <3-1. Registration processing>

First, in describing an operation of the information processing system 100, registration processing of registering information necessary for the operation of the information processing system 100 in the group management DB 13 and the adjustment log DB 14 will be described.

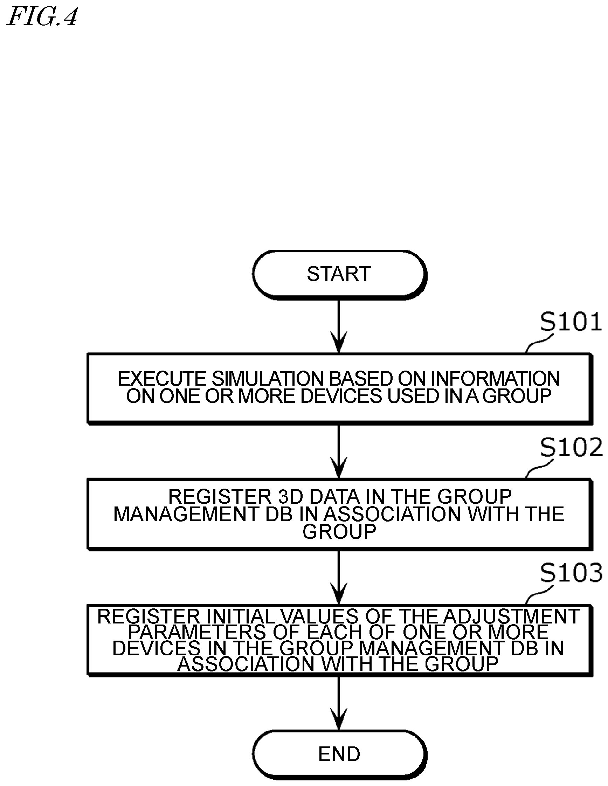

Fig. 4 is a flowchart illustrating an example of registering information in the group management DB 13 by execution of simulation. Here, the simulation is processing of simulating an operation of one or more devices by installing an object simulating each of the one or more devices in a virtual space simulating an installation location. The one or more devices include, for example, the projector 2A, the camera 3A, the marker 6, and the like. A terminal executing the simulation may be any one of the one or more terminals 4 or the information processing terminal 5. Further, a terminal executing the simulation may be a terminal other than the one or more terminals 4 and the information processing terminal 5.

First, an operator executes simulation by operating a terminal in which an application for simulation is installed. Here, an operator executes simulation based on information on one or more devices used in a group (S101). For example, an operator inputs information on each of "Camera 1", "Projector 1", and "Marker 1" used in a group indicated by "Group ID: 1" at the first installation location to the terminal, and executes simulation.

A terminal executing simulation generates 3D data including an object simulating each of one or more devices and a virtual space in which the object is installed. Here, the terminal generates 3D data including an object simulating each of "Camera 1", "Projector 1", and "Marker 1" and a virtual space simulating the first installation location where the object is installed.

Then, the terminal transmits 3D data to the server 1 (information processing system 100) via the network N1. When the 3D data is received by the communication unit 11, the processing unit 12 of the server 1 registers the received 3D data in the group management DB 13 in association with the group (S102). For example, when "Group ID: 1" is assigned to the 3D data, the processing unit 12 registers the 3D data in the group management DB 13 in association with "Group ID: 1".

Further, the terminal executing the simulation generates an adjustment parameter of each of one or more devices. Here, the terminal generates a position and an imaging area of "Camera 1", a position and a projection area of "Projector 1", and the number and a position of "Marker 1" as adjustment parameters of each of one or more devices.

Then, the terminal transmits data including the adjustment parameters of each of one or more devices to the server 1 (information processing system 100) via the network N1. When the data is received by the communication unit 11, the processing unit 12 of the server 1 registers initial values of the adjustment parameters of each of one or more devices included in the received data in the group management DB 13 in association with the group (S103). For example, when "Group ID: 1" is assigned to the data, the processing unit 12 registers the adjustment parameters of each of one or more devices included in the data in the group management DB 13 in association with "Group ID: 1" as initial values of the adjustment parameters of each of one or more devices. Here, a position and an imaging area of "Camera 1", a position and a projection area of "Projector 1", and the number and a position of "Marker 1" are registered in the group management DB 13 as initial values of the adjustment parameters of each of one or more devices.

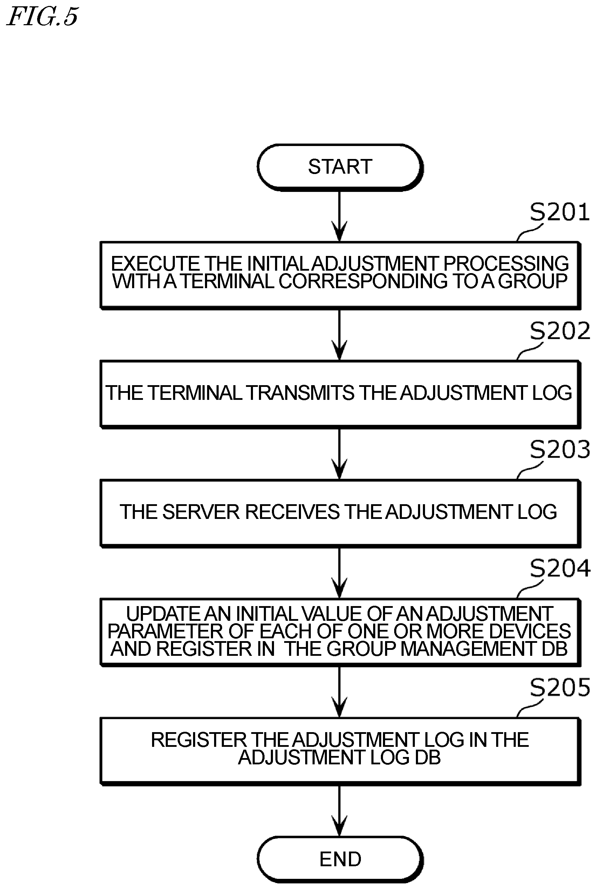

Fig. 5 is a flowchart illustrating an example of registering information in the group management DB 13 by execution of initial adjustment processing. Here, the initial adjustment processing is processing in which an operator actually installs one or more devices at an installation location and adjusts an adjustment parameter of each of the one or more devices while operating the one or more devices. In the embodiment, an operator executes the initial adjustment processing while referring to an execution result of the simulation.

First, an operator operates a terminal corresponding to a group (in other words, the terminal 4 installed at the installation location of one or more devices) to execute the initial adjustment processing (S201). For example, when executing the initial adjustment processing for a group indicated by "Group ID: 1", an operator executes the initial adjustment processing by operating the first terminal 4A installed at the first installation location. Specifically, in the initial adjustment processing, an operator inputs an adjustment parameter of each of one or more devices to the terminal. Here, the operator inputs, to the terminal, a position and an imaging area of "Camera 1", a position and a projection area of "Projector 1", and the number and a position of "Marker 1" at the first installation location.

The terminal executing the initial adjustment processing uses the input data as an adjustment log and stores the adjustment log in a memory included in the terminal. Further, the terminal transmits the adjustment log to the server 1 (information processing system 100) via the network N1 (S202). When the adjustment log is received by the communication unit 11 (S203), the processing unit 12 of the server 1 updates an initial value of an adjustment parameter of each of one or more devices based on the received adjustment log and registers the value in the group management DB 13 (S204). For example, when "Group ID: 1" is assigned to the adjustment log, the processing unit 12 updates an adjustment parameter of each of one or more devices associated with "Group ID: 1" registered in the group management DB 13 based on an adjustment parameter of each of one or more devices included in the adjustment log. Here, a position and an imaging area of "Camera 1", a position and a projection area of "Projector 1", and the number and a position of "Marker 1" included in the adjustment log are registered in the group management DB 13 as initial values of adjustment parameters of each of one or more devices.

Then, the processing unit 12 of the server 1 registers the received adjustment log in the adjustment log DB 14 (S205). For example, when "Group ID: 1" is assigned to the adjustment log, the processing unit 12 causes "Group ID: 1" and the adjustment log in association with each other to store in the adjustment log DB 14.

As described above, in the embodiment, an operator first executes simulation and then executes the initial adjustment processing, without limitation. For example, an operator may execute the initial adjustment processing without executing simulation.

### <3-2. Basic operation>

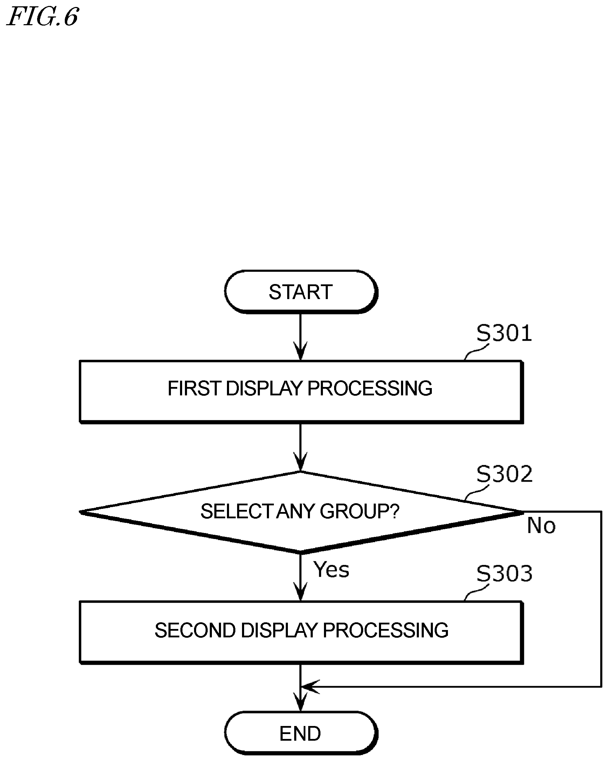

Next, a basic operation of the information processing system 100 according to the embodiment will be described. Fig. 6 is a flowchart illustrating an operation example of the information processing system 100 according to the embodiment. Hereinafter, description will be made on the assumption that a signal instructing to provide a GUI is transmitted from the information processing terminal 5 to the server 1 (information processing system 100) by the user through operation of the information processing terminal 5.

First, the processing unit 12 of the server 1 executes first display processing (S301). Specifically, the processing unit 12 reads one or more pieces of group information registered in the group management DB 13, and transmits the one or more pieces of group information to the information processing terminal 5 via the network N2. As a result, the display unit 52 of the information processing terminal 5 displays the received one or more pieces of group information.

Here, in a case where the user selects any group of one or more groups while viewing the one or more pieces of group information displayed on the display unit 52 (S302: Yes), the processing unit 12 of the server 1 executes the second display processing (S303). Specifically, when receiving information indicating selection of any group from the information processing terminal 5 via the communication unit 11, the processing unit 12 reads 3D data associated with the group registered in the group management DB 13, and transmits the 3D data to the information processing terminal 5 via the network N2. As a result, the display unit 52 of the information processing terminal 5 displays a virtual space (overhead view) of an installation location and an object included in the received 3D data. Note that in a case where the user does not select any group (S302: No), only one or more pieces of group information are continuously displayed on the display unit 52.

Note that when transmitting one or more pieces of group information to the information processing terminal 5, the processing unit 12 of the server 1 may also transmit 3D data corresponding to each piece of group information to the information processing terminal 5. In this case, when receiving an input to select any group, the information processing terminal 5 can display a virtual space and an object corresponding to the group on the display unit 52 without communicating with the server 1. Also in this case, the processing unit 12 of the server 1 can be considered to indirectly execute the second display processing via the information processing terminal 5.

### <3-3. Display example>

Hereinafter, a display example of various types of information displayed on the display unit 52 of the information processing terminal 5 will be described.

### <Basic display example>

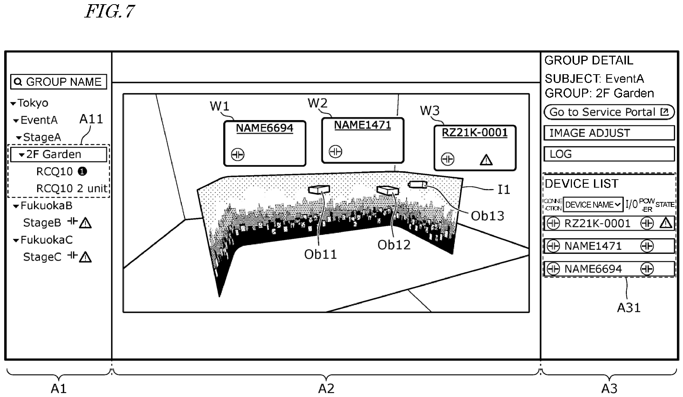

Fig. 7 is a diagram illustrating a basic display example on the display unit 52 of the information processing terminal 5 according to the embodiment. As illustrated in Fig. 7, the display unit 52 displays a first region A1, a second region A2, and a third region A3.

The first region A1 is a region in which one or more pieces of group information are displayed. In the example illustrated in Fig. 7, a plurality of pieces of group information are listed in the first region A1. A region indicated by a broken line in the first region A1 is a selection region A11 indicating group information selected by the user. Here, the user selects a "2F Garden" group included in a "Tokyo" group, an "EventA" group, and a "StageA" group.

The second region A2 is a region in which an overhead view (here, a virtual space) and an object corresponding to the group information selected in the first region A1 are displayed. In the example illustrated in Fig. 7, in the second region A2, a virtual space indicating an installation location corresponding to the "2F Garden" group, three first objects Ob11, Ob12, and Ob13 simulating three of the projectors 2A installed at the installation location, and a video I1 projected by the three projectors 2A are displayed.

As described above, in the basic display example, objects (here, the first objects Ob11 to Ob13) are not only displayed in the second region A2 but also are displayed in the second region A2, including the position in the virtual space (overhead view). That is, in the second display processing, a position of an object in an overhead view is further displayed on the display unit 52. Also, in the display example described below, an object is displayed on the display unit 52, including a position in an overhead view.

Further, in the second region A2, three detail windows W1, W2, and W3 indicating detailed information on each of the three first objects Ob11, Ob12, and Ob13 are displayed. For example, the detail window W1 displays a name of the projector 2A corresponding to the first object Ob11 and information indicating that power of the projector 2A is on.

The third region A3 is a region in which state information indicating a state of each of the projector 2A (output device 2) and the camera 3A (acquisition device 3) is displayed. In the example illustrated in Fig. 7, a state region A31 indicating a state of each of the three projectors 2A is displayed in the third region A3. Note that although not illustrated in Fig. 7, a state region indicating a state of the camera 3A may be displayed.

Note that in the example illustrated in Fig. 7, the second region A2 and the third region A3 are displayed on the display unit 52, but the second region A2 and the third region A3 do not need to be displayed on the display unit 52 until any group is selected in the first region A1. Further, the first region A1 and the second region A2 only need to be displayed on the display unit 52, and the third region A3 does not need to be displayed.

### <First display example>

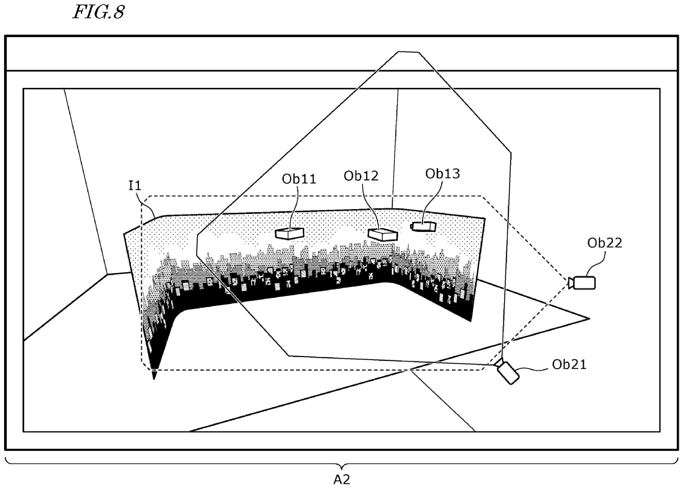

Fig. 8 is a diagram illustrating a first display example on the display unit 52 of the information processing terminal 5 according to the embodiment. In the example illustrated in Fig. 8, only the second region A2 displayed on the display unit 52 is illustrated. Further, in the example illustrated in Fig. 8, in the second region A2, a virtual space indicating an installation location corresponding to the "2F Garden" group, the three first objects Ob11, Ob12, and Ob13 simulating three of the projectors 2A installed at the installation location, and the video I1 projected by the three projectors 2A are displayed. Further, in the second region A2, two second objects Ob21 and Ob22 simulating two of the cameras 3A installed at the installation location are further displayed.

In Fig. 8, a region indicated by a trapezoidal solid line with reference to the second object Ob21 represents an imaging area of the camera 3A corresponding to the second object Ob21. Further, a region indicated by a trapezoidal broken line with reference to the second object Ob22 represents an imaging area of the camera 3A corresponding to the second object Ob22.

These regions are not displayed on the display unit 52 until the user selects one of the two second objects Ob21 and Ob22. Then, when the user selects one of the two second objects Ob21 and Ob22, an imaging area of the camera 3A corresponding to the selected second object is displayed on the display unit 52. As a result, the user can grasp the imaging area of the selected camera 3A.

### <Second display example>

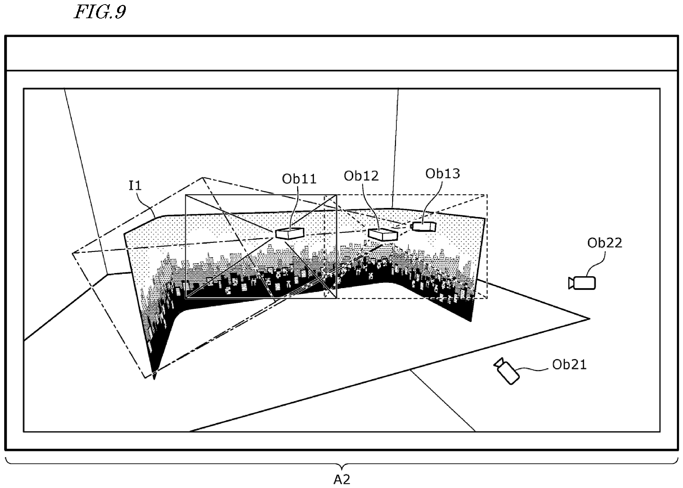

Fig. 9 is a diagram illustrating a second display example on the display unit 52 of the information processing terminal 5 according to the embodiment. In the example illustrated in Fig. 9, similarly to the first display example, only the second region A2 displayed on the display unit 52 is illustrated. Hereinafter, description of a point common to the first display example will be omitted.

In Fig. 9, a region indicated by a quadrangular-pyramidal solid line with reference to the first object Ob11 represents a projection area of the projector 2A corresponding to the first object Ob11. A region indicated by a quadrangular-pyramidal broken line with reference to the first object Ob12 represents a projection area of the projector 2A corresponding to the first object Ob12. Further, a region indicated by a quadrangular-pyramidal one-dot chain line with reference to the first object Ob13 represents a projection area of the projector 2A corresponding to the first object Ob13.

These regions are not displayed on the display unit 52 until the user selects one of the three first objects Ob11, Ob12, and Ob13. Then, when the user selects any one of the three first objects Ob11, Ob12, and Ob13, a projection area of the projector 2A corresponding to the selected first object is displayed on the display unit 52. As a result, the user can grasp a projection area of the selected projector 2A.

Here, before describing a third display example to a seventh display example, an example of third display processing of the information processing system 100 according to the embodiment will be described. All of the third display example to the seventh display example described below indicate various types of information displayed on the display unit 52 of the information processing terminal 5 by the third display processing.

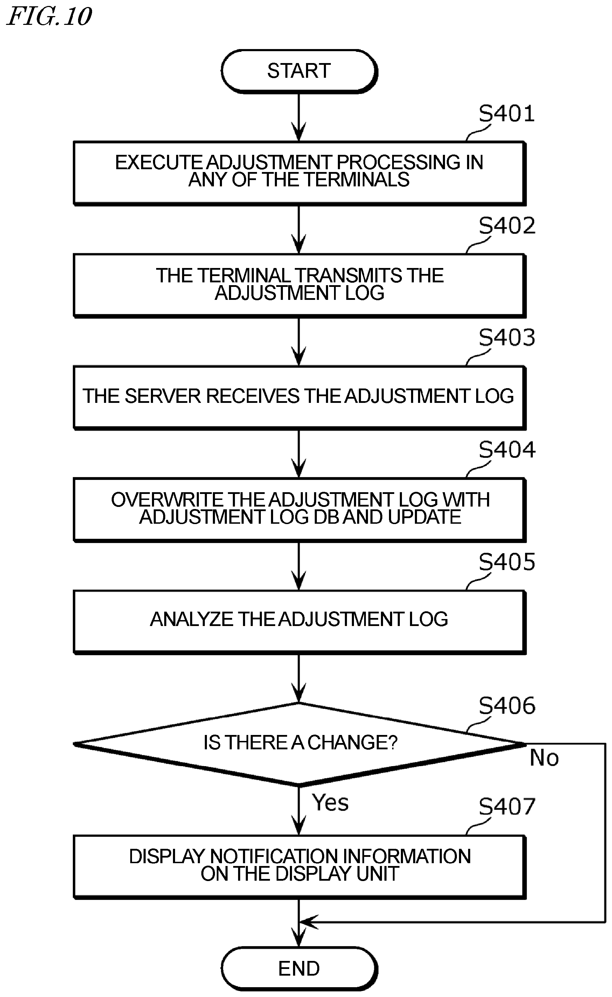

Fig. 10 is a flowchart illustrating an example of the third display processing of the information processing system 100 according to the embodiment. Hereinafter, description will be made on the assumption that the initial adjustment processing is already executed, that is, an initial value of an adjustment parameter of one or more devices is already set. Further, hereinafter, description will focus on adjustment processing in any one of a plurality of the terminals 4.

First, adjustment processing is executed in any of the terminals 4 (S401). Then, when the terminal 4 executes the adjustment processing, the terminal 4 uses an execution result of the adjustment processing as an adjustment log and transmits the adjustment log to the server 1 (information processing system 100) via the network N1 (S402).

When the adjustment log is received by the communication unit 11 (S403), the processing unit 12 of the server 1 overwrites the received adjustment log with an adjustment log stored in the adjustment log DB 14 to update the adjustment log (S404). For example, when "Group ID: 1" is assigned to the adjustment log, the processing unit 12 overwrites the adjustment log with an adjustment log associated with "Group ID: 1" stored in the adjustment log DB 14 to update the adjustment log.

Then, the processing unit 12 of the server 1 analyzes the received adjustment log (S405). Here, the processing unit 12 analyzes the adjustment log by comparing an adjustment parameter of each of one or more devices included in the received adjustment log with an initial value of an adjustment parameter of each of one or more devices registered in the group management DB 13. Note that Step S405 may be automatically executed when an adjustment log is received, or may be executed when the user performs a predetermined operation on the information processing terminal 5.

As a result of the analysis, in a case where there is a change in an adjustment parameter of any device (S406: Yes), the processing unit 12 of the server 1 transmits notification information indicating a change in a state of the device to the information processing terminal 5 via the network N2, so as to cause the display unit 52 of the information processing terminal 5 to display the notification information (S407). On the other hand, in a case where there is no change in an adjustment parameter of any device (S406: No), the processing unit 12 causes the display unit 52 to maintain current display of various types of information.

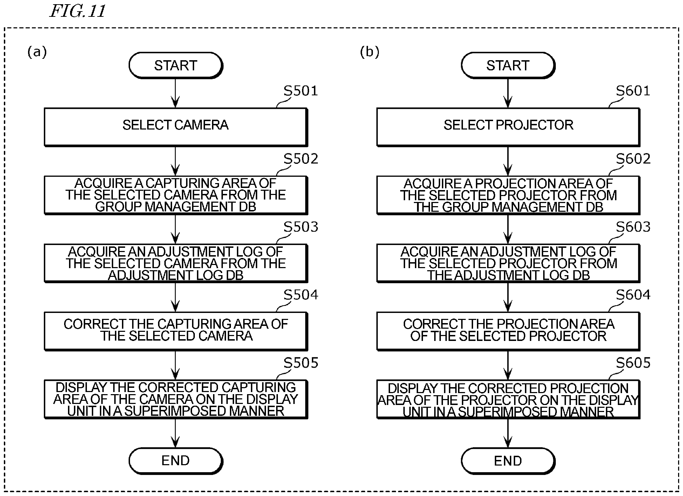

Fig. 11 is a flowchart illustrating a specific example of the third display processing by the information processing system 100 according to the embodiment. Part (a) of Fig. 11 illustrates an example of a case where there is a change in an imaging area of the camera 3A as an adjustment parameter of a device, and part (b) of Fig. 11 illustrates an example of a case where there is a change in a projection area of projector 2A as an adjustment parameter of a device. Note that the example illustrated in Fig. 11 represents a processing example executed by the user through operation of the information processing terminal 5 and selection of any device.

In the example illustrated in part (a) of Fig. 11, the user selects the camera 3A included in any group (S501). Then, the processing unit 12 of the server 1 reads and acquires an imaging area of the selected camera 3A associated with a group ID indicating the group from the group management DB 13 (S502). Further, the processing unit 12 reads and acquires an adjustment log associated with a group ID indicating the group from the adjustment log DB 14 (S503). Then, the processing unit 12 compares the imaging area of the selected camera 3A with an imaging area of the camera 3A included in the adjustment log, and corrects the imaging area of the selected camera 3A (S504). After that, the processing unit 12 causes the display unit 52 of the information processing terminal 5 to display the corrected imaging area of the camera 3A in a superimposed manner (S505). For this reason, an imaging area of the camera 3A before correction (that is, an initial value of the imaging area of the camera 3A) and an imaging area of the camera 3A after correction are displayed on the display unit 52. As a result, the user can grasp that there is a change in the imaging area of the camera 3A.

In the example illustrated in part (b) of Fig. 11, the user selects the projector 2A included in any group (S601). Then, the processing unit 12 of the server 1 reads and acquires a projection area of the selected projector 2A associated with a group ID indicating the group from the group management DB 13 (S602). Further, the processing unit 12 reads and acquires an adjustment log associated with a group ID indicating the group from the adjustment log DB 14 (S603). Then, the processing unit 12 compares the projection area of the selected projector 2A with a projection area of the projector 2A included in the adjustment log, and corrects the projection area of the selected projector 2A (S604). After that, the processing unit 12 causes the display unit 52 of the information processing terminal 5 to display the corrected projection area of the projector 2A in a superimposed manner (S605). For this reason, the projection area of the projector 2A before correction (that is, an initial value of a projection area of the projector 2A) and the projection area of the projector 2A after correction are displayed on the display unit 52. As a result, the user can grasp that there is a change in the projection area of the projector 2A.

### <Third display example>

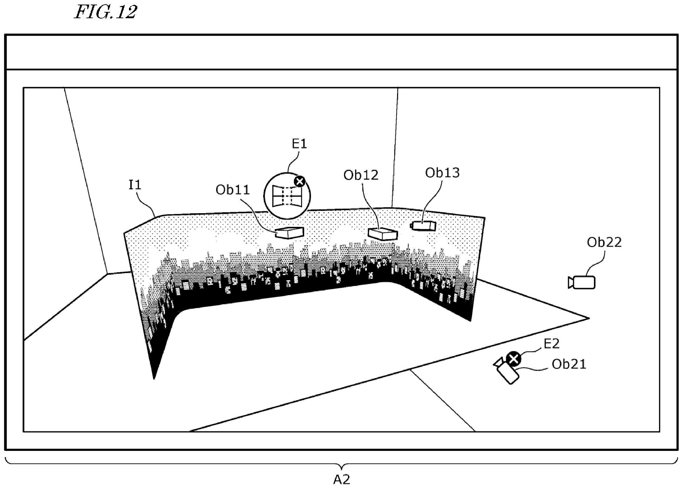

Fig. 12 is a diagram illustrating a third display example on the display unit 52 of the information processing terminal 5 according to the embodiment. In the example illustrated in Fig. 12, similarly to the first display example, only the second region A2 displayed on the display unit 52 is illustrated. Hereinafter, description of a point common to the first display example will be omitted.

In Fig. 12, an error icon E1 in the vicinity of the first object Ob11 indicates some kind of change in a state of the projector 2A corresponding to the first object Ob11. Further, an error icon E2 in the vicinity of the second object Ob21 indicates some kind of change in a state of the camera 3A corresponding to the second object Ob21. The user can grasp that there is some kind of change in each of a state of the projector 2A and a state of the camera 3A by viewing the error icons E1 and E2.

### <Fourth display example>

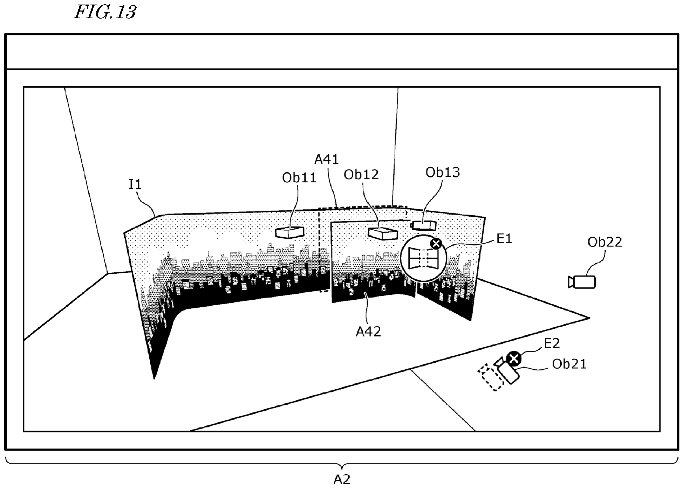

Fig. 13 is a diagram illustrating a fourth display example on the display unit 52 of the information processing terminal 5 according to the embodiment. In the example illustrated in Fig. 13, similarly to the third display example, only the second region A2 displayed on the display unit 52 is illustrated. Hereinafter, description of a point common to the third display example will be omitted.

In Fig. 13, a rectangular region A41 indicated by a broken line in the vicinity of the first object Ob11 represents an initial projection area of the projector 2A corresponding to the first object Ob11. Further, a rectangular region A42 indicated by a solid line in the vicinity of the first object Ob11 represents a current projection area of the projector 2A corresponding to the first object Ob11. By viewing these regions A41 and A42, the user can grasp in which direction and how much a projection area of the projector 2A is deviated from an initial projection area.

Further, in Fig. 13, the second object Ob21 indicated by a broken line represents an initial position of the camera 3A corresponding to the second object Ob21. Further, the second object Ob21 indicated by a solid line represents a current position of the camera 3A corresponding to the second object Ob21. By viewing the second objects Ob21, the user can grasp in which direction and how much a position of the camera 3A is deviated from an initial position.

### <Fifth display example>

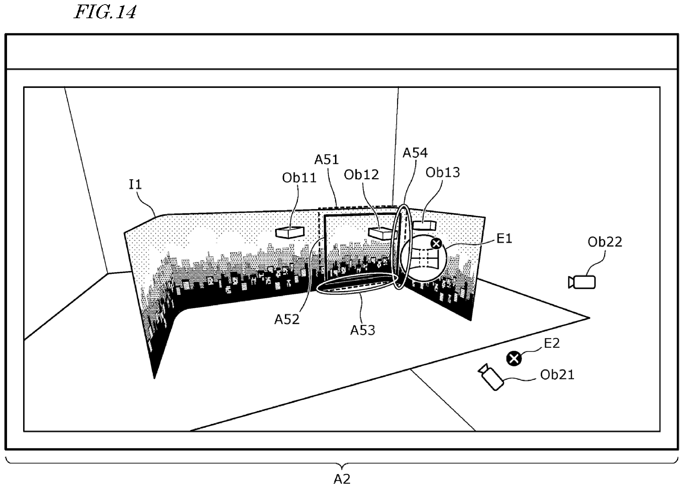

Fig. 14 is a diagram illustrating a fifth display example on the display unit 52 of the information processing terminal 5 according to the embodiment. In the example illustrated in Fig. 14, similarly to the third display example, only the second region A2 displayed on the display unit 52 is illustrated. Hereinafter, description of a point common to the third display example will be omitted.

In Fig. 14, a rectangular region A51 indicated by a broken line represents a correctable limit of a projection area of the projector 2A corresponding to the first object Ob11. Further, a rectangular region A52 indicated by a solid line represents a current projection area of the projector 2A corresponding to the first object Ob11. Further, two elliptical regions A53 and A54 indicate that a correctable range of a projection area of the projector 2A corresponding to the first object Ob11 is approaching its limit. By viewing the regions A51 to A54, the user can grasp that a correctable range of a projection area of the projector 2A corresponding to the first object Ob11 is approaching its limit.

### <Sixth display example>

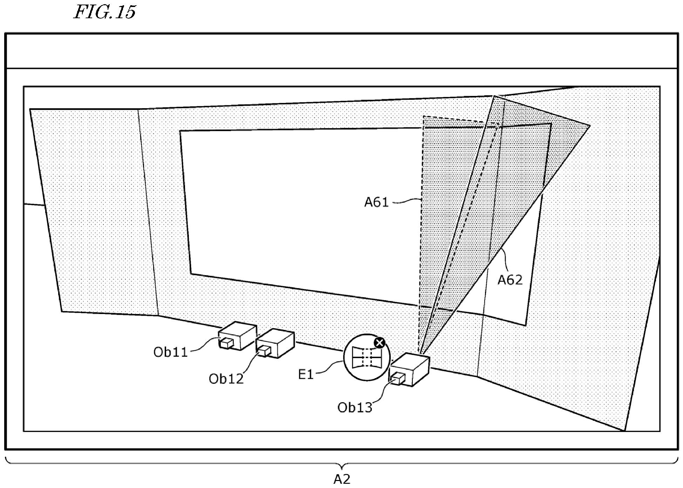

Fig. 15 is a diagram illustrating a sixth display example on the display unit 52 of the information processing terminal 5 according to the embodiment. In the example illustrated in Fig. 15, similarly to the third display example, only the second region A2 displayed on the display unit 52 is illustrated. Hereinafter, description of a point common to the third display example will be omitted.

In the example illustrated in Fig. 15, three of the first objects Ob11, Ob12, and Ob13 simulating three of the projectors 2A installed on the ground are displayed in the second region A2. In Fig. 15, a region A61 indicated by a triangular broken line with reference to the first object Ob13 represents an initial adjustment region of a black level of the projector 2A corresponding to the first object Ob13. Further, a region A62 indicated by a triangular solid line with reference to the first object Ob13 represents a current adjustment region of a black level of the projector 2A corresponding to the first object Ob13. By viewing the triangular regions A61 and A62, the user can grasp that an adjustment region of black level is deviated due to positional deviation of the projector 2A.

### <Seventh display example>

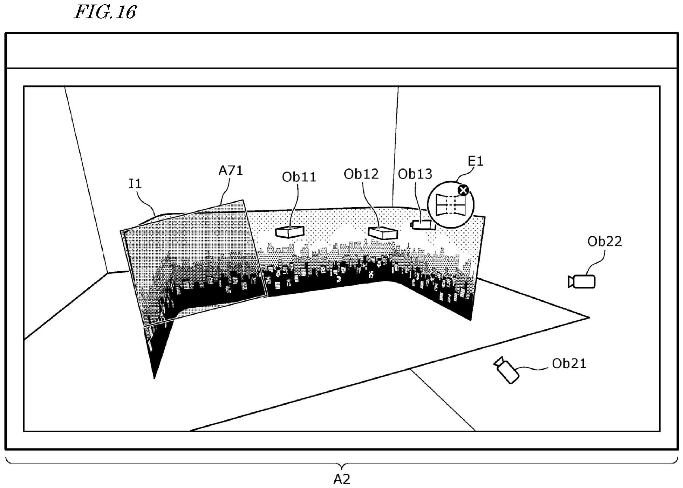

Fig. 16 is a diagram illustrating a seventh display example on the display unit 52 of the information processing terminal 5 according to the embodiment. In the example illustrated in Fig. 16, similarly to the third display example, only the second region A2 displayed on the display unit 52 is illustrated. Hereinafter, description of a point common to the third display example will be omitted.

In the video I1 illustrated in Fig. 16, a rectangular region A71 darker than other regions indicates that brightness of a light source of the projector 2A whose projection area is the region is lower than that in an initial state. Here, whether or not brightness of a light source of the projector 2A is lower than that in an initial state can be estimated by, for example, an appropriate light source lifetime analysis algorithm. The user can grasp that lifetime of a light source of the projector 2A is shortened by viewing the rectangular region A71.

In the first to seventh display examples described above, a virtual space simulating an installation location is displayed as an overhead view on the display unit 52 of the information processing terminal 5, without limitation. For example, the display unit 52 of the information processing terminal 5 may display a planar map including an installation location as an overhead view as in an eighth display example described below.

### <Eighth display example>

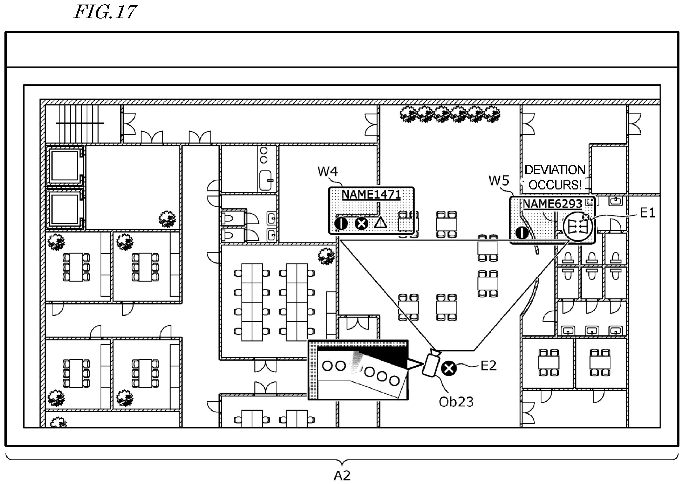

Fig. 17 is a diagram illustrating an eighth display example on the display unit 52 of the information processing terminal 5 according to the embodiment. In the example illustrated in Fig. 17, only the second region A2 displayed on the display unit 52 is illustrated. Further, in the example illustrated in Fig. 17, a planar map including an installation location corresponding to group information selected in the first region A1 is displayed as an overhead view in the second region A2. Further, in the example illustrated in Fig. 17, a second object Ob23 simulating the camera 3A installed at the installation location and two detail windows W4 and W5 corresponding to two projectors 2A (not illustrated) are displayed. Note that, in Fig. 17, a region indicated by a trapezoidal solid line with reference to the second object Ob23 represents an imaging area of the camera 3A corresponding to the second object Ob23.

In the vicinity of the second object Ob23, the error icon E2 indicating some kind of change in a state of the corresponding camera 3A is displayed. Further, the error icon E1 indicating some kind of change in a state of the corresponding projector 2A is displayed in the detail window W5. Further, in the vicinity of the detail window W5, content of an error of the corresponding projector 2A (here, deviation of a projection area) is displayed as a character string.

The user can grasp the projector 2A and the camera 3A at the installation location by viewing the second region A2. Further, the user can view a video captured by the camera 3A by performing an operation of selecting the second object Ob23. In the example illustrated in Fig. 17, a video captured by the camera 3A is displayed on the left side of the second object Ob23. By viewing this video, the user can grasp that a deviation occurs between projection areas of the two projectors 2A.

### [4. Advantage and the like]

Hereinafter, an advantage of the information processing system 100 (information processing method) according to the embodiment will be described. As described above, in the system described in [1. Knowledge underlying the present disclosure], there is a problem that while the user can grasp a state of a projector to be monitored, the user cannot intuitively grasp which camera is monitoring the projector to be monitored. In other words, in the system, there is a problem that while the user can grasp information regarding an output device (projector), the user cannot grasp information regarding an acquisition device (camera). As a result, there is a problem that the user who uses the system needs to perform work of associating an acquisition device with an output device, and an operation required for constructing the system tends to be complicated. Further, in the system, there is also a problem that the user may associate an incorrect acquisition device with an output device.

On the other hand, in the information processing system 100 according to the embodiment, one or more pieces of group information including information regarding the output device 2 (the projector 2A) and information regarding the acquisition device 3 (the camera 3A) can be displayed on the display unit 52. Further, in the information processing system 100 according to the embodiment, in a case where any group information is selected, it is possible to cause the display unit 52 to display an overhead view illustrating installation locations of the output device 2 (the projector 2A) and the acquisition device 3 (the camera 3A) included in the selected group information, and objects indicating the output device 2 and the acquisition device 3. For this reason, in the information processing system 100 according to the embodiment, since the user can grasp what kind of the output device 2 and the acquisition device 3 are installed at an installation location by viewing the display unit 52, there is an advantage that it is easy to grasp not only information regarding the output device 2 but also information regarding the acquisition device 3. Further, there is an advantage that the user does not need to perform an operation of associating the acquisition device 3 with the output device 2, and the user does not inadvertently associate the incorrect acquisition device 3 with the output device 2.

### [5. Other embodiments]

Although the embodiment is described above, the present disclosure is not limited to the embodiment described above.

For example, in the embodiment described above, the information processing system 100 causes the display unit 52 of the information processing terminal 5 to display various types of information on, without limitation. For example, the information processing system 100 may use a display included in the server 1 as a display unit and cause the display to display various types of information.

Further, in the embodiment described above, the information processing system 100 is implemented by a single device (server 1), without limitation. For example, the information processing system 100 may be implemented by a plurality of devices. That is, a plurality of components included in the information processing system 100 may be distributed to two or more devices.

Further, in the embodiment described above, the information processing system 100 is implemented by the server 1, without limitation. For example, the information processing system 100 may be included in an information processing terminal such as a personal computer installed in a closed space. That is, the information processing system 100 may be implemented by cloud computing or edge computing.

Further, in the embodiment described above, processing executed by a specific processing unit may be executed by another processing unit. Further, order of a plurality of processes may be changed, or a plurality of processes may be executed in parallel.

Further, in the embodiment described above, each component may be implemented by executing a software program suitable for each component. Each component may be implemented by a program execution unit such as a CPU or a processor reading and executing a software program recorded in a recording medium such as a hard disk or a semiconductor memory.

Further, each component may be implemented by hardware. Each component may be a circuit (or an integrated circuit). These circuits may constitute one circuit as a whole or may be separate circuits. Each of these circuits may be a general-purpose circuit or a dedicated circuit.

Further, a general or specific aspect of the present disclosure may be realized by a system, a device, a method, an integrated circuit, a computer program, or a computer-readable recording medium such as a CD-ROM. Further, the general or specific aspect may be implemented by any combination of a system, a device, a method, an integrated circuit, a computer program, and a recording medium.

Further, the present disclosure may be implemented as an information processing method executed by a computer such as the information processing system of the embodiment described above. The present disclosure may be implemented as a program (computer program product) for causing a computer to execute such an information processing method, or may be implemented as a non-transitory computer-readable recording medium in which such a program is recorded.

In addition, the present disclosure also includes an aspect obtained by applying various modifications conceived by those skilled in the art to each embodiment, or an aspect implemented by any combination of components and functions in each embodiment without departing from the spirit of the present disclosure.

### (Conclusion)

As described above, the information processing method according to a first aspect includes the first display processing and the second display processing. The first display processing is processing of causing the display unit 52 to display one or more pieces of group information each including information regarding the output device 2 that outputs predetermined information and information regarding the acquisition device 3 that acquires the predetermined information output by the output device 2. The second display processing is processing of causing the display unit 52 to display, in a case where any group information among the one or more pieces of group information is selected: an overhead view illustrating installation locations of the output device 2 and the acquisition device 3 included in the selected group information; and objects indicating the output device 2 and the acquisition device 3.

In such an information processing method, the user can grasp what kind of the output device 2 and the acquisition device 3 are installed at the installation location by viewing the display unit 52. For this reason, in such an information processing method, there is an advantage that the user can easily grasp not only information regarding the output device 2 that outputs predetermined information but also information regarding the acquisition device 3 that acquires the predetermined information output by the output device 2.

Further, for example, in the information processing method according to a second aspect, in the first aspect, the second display processing further causes the display unit 52 to display a position of the objects in the overhead view.

In such an information processing method, there is an advantage that the user can easily grasp positions where the output device 2 and the acquisition device 3 are installed at the installation location by viewing positions of objects displayed on the display unit 52.

Further, for example, in the information processing method according to a third aspect, in the first or second aspect, the second display processing further causes the display unit 52 to display state information indicating a state of each of the output device 2 and the acquisition device 3.

In such an information processing method, there is an advantage that the user can easily grasp a state of each of the output device 2 and the acquisition device 3 by viewing the state of each of the output device 2 and the acquisition device 3 displayed on the display unit 52.

Further, for example, in the information processing method according to a fourth aspect, in any one of the first to third aspects, at least one of the one or more pieces of group information is obtained by installing the objects in a virtual space simulating the installation location and executing simulation simulating an operation of the output device 2 and the acquisition device 3.

In such an information processing method, since group information can be displayed on the display unit 52 before the user actually installs the output device 2 and the acquisition device 3 at the installation location by executing simulation, there is an advantage that the user can easily grasp the group information.

Further, for example, the information processing method according to a fifth aspect further includes, in the third aspect, third display processing of causing the display unit 52 to display, in a case where a state of at least one of the output device 2 and the acquisition device 3 changes from a reference state, notification information indicating a change in the state information.

In such an information processing method, there is an advantage that the user can easily grasp that there is a change in a state of at least one of the output device 2 and the acquisition device 3 by viewing notification information displayed on the display unit 52.

Further, for example, in the information processing method according to a sixth aspect, in any one of the first to fifth aspects, the output device 2 is a display device (the projector 2A) that outputs a video, and the acquisition device 3 is the camera 3A that captures and acquires the video output by the display device.

In such an information processing method, since the user can grasp what kind of the display device and the camera 3A are installed at the installation location by viewing the display unit 52, there is an advantage that the user can easily grasp not only information regarding the display device but also information regarding the camera 3A.

Further, for example, in the information processing method according to a seventh aspect, in the sixth aspect, the second display processing causes the display unit 52 to display an area (projection area) of a video output from the display device (projector 2A) and an imaging area of the camera 3A.

In such an information processing method, there is an advantage that the user can easily grasp how the display device (projector 2A) outputs a video and how the camera 3A captures the video by viewing an area of the video and an imaging area displayed on the display unit 52.

Further, for example, the information processing system 100 according to an eighth aspect includes the processing unit 12. The processing unit 12 executes the first display processing and the second display processing. The first display processing is processing of causing the display unit 52 to display one or more pieces of group information each including information regarding the output device 2 that outputs predetermined information and information regarding the acquisition device 3 that acquires the predetermined information output by the output device 2. The second display processing is processing of causing the display unit 52 to display, in a case where any group information among the one or more pieces of group information is selected: an overhead view illustrating installation locations of the output device 2 and the acquisition device 3 included in the selected group information; and objects indicating the output device 2 and the acquisition device 3.

In the information processing system 100, the user can grasp what kind of the output device 2 and the acquisition device 3 are installed at the installation location by viewing the display unit 52. For this reason, in the information processing system 100, there is an advantage that the user can easily grasp not only information regarding the output device 2 that outputs predetermined information but also information regarding the acquisition device 3 that acquires the predetermined information output by the output device 2.

### INDUSTRIAL APPLICABILITY

The present disclosure can be used for, for example, a system for monitoring an output device and an acquisition device.

### REFERENCE SIGNS LIST

- 1: server
- 2: output device
- 3: acquisition device
- 4: terminal
- 5: information processing terminal
- 6: marker
- 11: communication unit
- 12: processing unit
- 13: group management DB
- 14: adjustment log DB
- 2A: projector
- 3A: camera
- 41: communication unit
- 42: adjustment unit
- 4A: first terminal
- 4B: second terminal
- 51: communication unit
- 52: display unit
- 100: information processing system
- A1: first region
- A2: second region
- A3: third region
- A11: selection region
- A31: state region
- A41, A42, A51~A54, A61, A62, A71: region
- E1, E2: error icon
- I1: video
- N1, N2: network
- Ob11, Ob12, Ob13: first object
- Ob21, Ob22, Ob23: second object
- W1, W2, W3, W4, W5: detail window

## Claims

1. An information processing method comprising:
first display processing of causing a display unit to display one or more pieces of group information each including information regarding an output device that outputs predetermined information and information regarding an acquisition device that acquires the predetermined information output by the output device; and
second display processing of causing the display unit to display, in a case where any group information among the one or more pieces of group information is selected: an overhead view illustrating installation locations of the output device and the acquisition device included in the selected group information; and objects indicating the output device and the acquisition device.

2. The information processing method according to claim 1, wherein
in the second display processing, a position of the objects in the overhead view is further displayed on the display unit.

3. The information processing method according to claim 1 or 2, wherein
in the second display processing, state information indicating a state of each of the output device and the acquisition device is further displayed on the display unit.

4. The information processing method according to claim 1 or 2, wherein
at least one of the one or more pieces of group information is obtained by installing the objects in a virtual space simulating the installation location and executing simulation simulating an operation of the output device and the acquisition device.

5. The information processing method according to claim 3, further comprising third display processing of causing the display unit to display, in a case where a state of at least one of the output device and the acquisition device changes from a reference state, notification information indicating a change in the state information.

6. The information processing method according to claim 1 or 2, wherein
the output device is a display device that outputs a video, and
the acquisition device is a camera that captures and acquires a video output from the display device.

7. The information processing method according to claim 6, wherein
in the second display processing, an area of the video output from the display device and an imaging area of the camera are further displayed on the display unit.

8. An information processing system comprising a processing unit that executes:
first display processing of causing a display unit to display one or more pieces of group information each including information regarding an output device that outputs predetermined information and information regarding an acquisition device that acquires the predetermined information output by the output device; and
second display processing of causing the display unit to display, in a case where any group information among the one or more pieces of group information is selected: an overhead view illustrating installation locations of the output device and the acquisition device included in the selected group information; and objects indicating the output device and the acquisition device.
